# EUROPÄISCHE PATENTSCHRIFT

(11) **EP 2 541 648 B1**
(45) Veröffentlichungstag und Bekanntmachung des Hinweises auf die Patenterteilung: **04.06.2014**
(21) Anmeldenummer: 12173664.9
(22) Anmeldetag: 26.06.2012
(51) Int. Cl.: H01M 2/20, H01M 10/48, H01R 11/28, H01M 2/32, G01R 31/36

(54) **Elektrochemische Vorrichtung**
Electrochemical device
Dispositif électrochimique

(30) Priorität: 30.06.2011 DE 102011051462
(43) Veröffentlichungstag der Anmeldung: 02.01.2013
(73) Patentinhaber: ElringKlinger AG, 72581 Dettingen (DE)
(72) Erfinder: Groshert, Jan, 72581 Dettingen/Erms (DE); Diez, Armin, 73252 Lenningen (DE)
(74) Vertreter: Hoeger, Stellrecht & Partner Patentanwälte

(56) Entgegenhaltungen:
- WO-A1-2010/142679
- WO-A1-2011/021452
- DE-A1-102009 050 316

## Beschreibung

Die vorliegende Erfindung betrifft eine elektrochemische Vorrichtung, umfassend mindestens eine erste elektrochemische Zelle mit einem ersten Zellterminal und eine zweite elektrochemische Zelle mit einem zweiten Zellterminal und mindestens einen Zellverbinder zum elektrisch leitenden Verbinden des ersten Zellterminals und des zweiten Zellterminals, wobei der Zellverbinder einen Grundkörper und einen Kontaktkörper, der mit dem Grundkörper verbunden ist und im montierten Zustand des Zellverbinders mit einem der Zellterminals verbunden ist, umfasst.

Solche elektrochemische Vorrichtungen können insbesondere als elektrische Akkumulatoren, beispielsweise als Lithium-Ionen-Akkumulatoren, ausgebildet sein.

Bei einem Lithium-Ionen-Akkumulator beträgt die Spannungsdifferenz zwischen den beiden Zellterminals (Polen) einer einzelnen Akkumulatorzelle ungefähr 3,6 V. Um ein für viele Anwendungen, beispielsweise in der Automobil-Antriebstechnik, benötigtes höheres Spannungsniveau von beispielsweise ungefähr 360 V zu erhalten, müssen viele solcher Akkumulatorzellen (beispielsweise ungefähr 100) elektrisch in Reihe geschaltet werden.

Die Akkumulatorzellen oder allgemein elektrochemischen Zellen können dabei zu Modulen zusammengefasst werden, welche jeweils mehrere solcher elektrochemischer Zellen enthalten, wobei die Einbaurichtung nebeneinander angeordneter Zellen alterniert, so dass positive und negative Zellterminals abwechselnd nebeneinander liegen.

Diese einander benachbarten Zellterminals entgegengesetzter Polarität werden für die Reihenschaltung der Zellen mittels jeweils eines Zellverbinders direkt miteinander verbunden.

Der mit dem Grundkörper verbundene Kontaktkörper dient dazu, eine zuverlässige, betriebssichere und einen geringen Kontaktwiderstand aufweisende Verbindung des Zellverbinders mit dem betreffenden Zellterminal zu erzielen.

Um eine Einzelzellenüberwachung zu bewerkstelligen, werden elektrische Potentialunterschiede zwischen verschiedenen Zellverbindern gemessen. Bei bekannten Potentialüberwachungen sind die Messstellen mittels Kabel, Draht oder leitfähigem Material in eine Leiterplatte eingelötet.

Die DE 10 2009 050316 A1 und die WO 2010/142679 A1 offenbaren elektrochemische Vorrichtungen gemäß dem Oberbegriff von Anspruch 1.

Die WO 2011/021452 A1 offenbart einen Zellverbinder mit einem zweilagig gefalteten Grundkörper.

Der vorliegenden Erfindung liegt die Aufgabe zugrunde, das elektrische Potential an dem Zellverbinder in besonders einfacher Weise erfassen und auswerten zu können.

Diese Aufgabe wird bei einer elektrochemischen Vorrichtung mit den Merkmalen des Oberbegriffs von Anspruch 1 erfindungsgemäß dadurch gelöst, dass der Kontaktkörper einen Spannungsabgriff umfasst.

Der vorliegenden Erfindung liegt somit das Konzept zugrunde, die Funktion des Spannungsabgriffs in den Kontaktkörper des Zellverbinders zu integrieren.

Auf diese Weise werden zusätzliche Bauteile und Materialübergänge eingespart. Bei der erfindungsgemäßen Lösung wird kein Zusatzmaterial und keine Beschichtung von bereits eingesetztem Material benötigt, um die Spannungsabgriffsfunktion an dem Zellverbinder bereitzustellen.

Die Zellspannungsmessung kann vielmehr direkt über ein bereits vorhandenes Bauteil, nämlich den Kontaktkörper, realisiert werden.

Insbesondere ist für die Erfassung des elektrischen Potentials an dem Zellverbinder keine Beschichtung an dem Grundkörper erforderlich. Eine solche Beschichtung kann nämlich sonst erforderlich sein, um die Einlötbarkeit einer Messstelle zu gewährleisten, insbesondere dann, wenn der Grundkörper beispielsweise aus Aluminium oder einer Aluminiumlegierung gebildet ist.

Ferner ist für die Erfassung des elektrischen Potentials an dem Zellverbinder kein Aufbringen von Elementen aus einem anderen leitfähigen Material, beispielsweise aus Kupfer oder einer Kupferlegierung, auf den Zellverbinder erforderlich.

Durch den Wegfall von Zusatzmaterialien und Zusatz-Beschichtungen werden durch die erfindungsgemäße Lösung die Produktionskosten gesenkt.

Da Materialübergänge, an denen ein korrosiver Angriff stattfinden könnte, eingespart werden, wird die Korrosionsbeständigkeit des erfindungsgemäßen Zellverbinders erhöht. Insbesondere kann ein sonst erforderlicher Korrosionsschutz entfallen.

Der Kontaktkörper ist vorzugsweise stoffschlüssig mit dem Grundkörper verbunden, beispielsweise durch Verschweißung, Verlötung und/oder Verklebung.

Der Kontaktkörper ist an einer im montierten Zustand des Zellverbinders den Zellterminals zugewandten Seite des Grundkörpers festgelegt.

Ferner ist vorzugsweise vorgesehen, dass der Kontaktkörper im montierten Zustand des Zellverbinders zwischen dem Grundkörper und einem der Zellterminals angeordnet ist.

Der Spannungsabgriff des Kontaktkörpers ist vorzugsweise stegförmig ausgebildet.

Bei einer bevorzugten Ausgestaltung der Erfindung ist vorgesehen, dass der Kontaktkörper einen Kontaktbereich umfasst, der im montierten Zustand des Zellverbinders mit einer Fügefläche des Grundkörpers verbunden ist und einstückig mit dem Spannungsabgriff ausgebildet ist.

Besonders günstig ist es für die Handhabung des Kontaktkörpers und des unter dessen Verwendung hergestellten Zellverbinders, wenn der Kontaktkörper insgesamt einstückig ausgebildet ist und somit alle Bestandteile des Kontaktkörpers einstückig miteinander verbunden sind.

Bei einer besonderen Ausgestaltung der Erfindung ist vorgesehen, dass der Grundkörper ein erstes Material und der Kontaktkörper ein zweites Material, das von dem ersten Material verschieden ist, umfasst.

Vorzugsweise ist der Grundkörper im Wesentlichen vollständig aus dem ersten Material gebildet.

Ferner ist der Kontaktkörper vorzugsweise im Wesentlichen vollständig aus dem zweiten Material gebildet.

Vorzugsweise umfasst der Grundkörper Aluminium und/oder Kupfer.

Insbesondere kann vorgesehen sein, dass der Grundkörper Aluminium oder Kupfer als Hauptbestandteil enthält.

Als Hauptbestandteil eines Materials gilt dabei derjenige Bestandteil, welcher den höchsten Gewichtsanteil an dem betreffenden Material aufweist.

Der Grundkörper kann insbesondere aus einer Aluminiumlegierung oder aus einer Kupferlegierung gebildet sein.

Der Kontaktkörper umfasst vorzugsweise Nickel.

Insbesondere kann vorgesehen sein, dass der Kontaktkörper Nickel als Hauptbestandteil umfasst.

Der Kontaktkörper kann insbesondere aus einer Nickellegierung gebildet sein.

Die Verwendung eines ganz oder teilweise aus Nickel gebildeten Kontaktkörpers ist insbesondere dann von Vorteil, wenn das Zellterminal, mit welchem der Kontaktkörper im montierten Zustand des Zellverbinders verbunden ist, selbst Nickel, vorzugsweise als Hauptbestandteil, oder eine Beschichtung mit Nickel, vorzugsweise als Hauptbestandteil, umfasst.

Der Kontaktkörper ist vorzugsweise stoffschlüssig mit dem Grundkörper des Zellverbinders verbunden.

Insbesondere kann vorgesehen sein, dass der Grundkörper durch Verschwei-βung, insbesondere durch Ultraschallschweißung, mit dem Grundkörper verbunden ist.

Der Spannungsabgriff des Kontaktkörpers weist vorzugsweise ein Kontaktierungselement zum Anschließen an eine Spannungsabgriffsleitung der elektrochemischen Vorrichtung auf.

Ein solches Kontaktierungselement kann beispielsweise als ein Lötpin ausgebildet sein.

Bei einer bevorzugten Ausgestaltung ist vorgesehen, dass der Kontaktkörper nur mit einem der Zellterminals, welche mittels des Zellverbinders elektrisch leitend miteinander verbunden sind, verbunden ist.

Der Kontaktkörper ist vorzugsweise stoffschlüssig mit einem der Zellterminals verbunden.

Der Kontaktkörper kann insbesondere durch Verschweißen, insbesondere Laserschweißen, mit einem der Zellterminals verbunden sein.

Bei einer bevorzugten Ausgestaltung der Erfindung ist vorgesehen, dass das mit dem Kontaktkörper verbundene Zellterminal eine Kontaktfläche aufweist, welche denselben Hauptbestandteil aufweist wie der Kontaktkörper.

Insbesondere kann vorgesehen sein, dass die Kontaktfläche des mit dem Kontaktkörper verbundenen Zellterminals Nickel, vorzugsweise als Hauptbestandteil, enthält.

Die elektrochemische Vorrichtung, in welcher der Zellverbinder eingesetzt wird, kann insbesondere als ein Akkumulator, beispielsweise als ein Lithium-Ionen-Akkumulator, ausgebildet sein.

Wenn die erfindungsgemäße elektrochemische Vorrichtung als ein Akkumulator ausgebildet ist, eignet sie sich insbesondere als eine hoch belastbare Energiequelle, beispielsweise für den Antrieb von Kraftfahrzeugen.

Der Kontaktkörper des Zellverbinders dient insbesondere als Schweißhilfe, welche ein stoffschlüssiges Verbinden des Zellverbinders mit einem Zellterminal einer elektrochemischen Zelle durch Verschweißen, insbesondere durch Laserschweißen, erleichtert.

Die vorliegende Erfindung betrifft ferner ein Verfahren zum Herstellen einer elektrisch leitenden Verbindung zwischen einem ersten Zellterminal einer ersten elektrochemischen Zelle und einem zweiten Zellterminal einer zweiten elektrochemischen Zelle.

Der vorliegenden Erfindung liegt die weitere Aufgabe zugrunde, ein solches Verfahren zu schaffen, durch welches in besonders einfacher Weise eine solche elektrisch leitende Verbindung hergestellt wird, an welcher ein elektrisches Potential erfassbar ist.

Diese Aufgabe wird erfindungsgemäß durch ein Verfahren zum Herstellen einer elektrisch leitenden Verbindung zwischen einem ersten Zellterminal einer ersten elektrochemischen Zelle und einem zweiten Zellterminal einer zweiten elektrochemischen Zelle gelöst, welches folgende Verfahrensschritte umfasst:
- Herstellen eines Grundkörpers eines Zellverbinders;
- Herstellen eines Kontaktkörpers eines Zellverbinders separat von dem Grundkörper, wobei der Kontaktkörper einen Spannungsabgriff umfasst;
- Verbinden des Kontaktkörpers mit dem Grundkörper, wobei der Kontaktkörper an einer im montierten Zustand des Zellverbinders den Zellterminals zugewandten Seite des Grundkörpers festgelegt wird;
- Verbinden eines der Zellterminals mit dem Kontaktkörper;
- Verbinden des Zellverbinders mit dem anderen Zellterminal;
- Verbinden des Spannungsabgriffs mit einer Spannungsabgriffsleitung der elektrochemischen Vorrichtung.

Besondere Ausgestaltungen des erfindungsgemäßen Verfahrens wurden bereits vorstehend im Zusammenhang mit dem erfindungsgemäßen Zellverbinder und der erfindungsgemäßen elektrochemischen Vorrichtung erläutert.

Weitere Merkmale und Vorteile der Erfindung sind Gegenstand der nachfolgenden Beschreibung und der zeichnerischen Darstellung eines Ausführungsbeispiels.

In den Zeichnungen zeigen:
- Fig. 1: eine schematische Seitenansicht eines Zellverbinders und zweier elektrochemischer Zellen, deren Zellterminals mittels des Zellverbinders miteinander verbunden sind;
- Fig. 2: eine schematische Draufsicht von oben auf die den Zellterminals der elektrochemischen Zellen abgewandte Seite des Zellverbinders aus Fig. 1;
- Fig. 3: eine schematische Draufsicht auf einen Grundkörper des Zellverbinders aus den Fig. 1 und 2; und
- Fig. 4: eine schematische Draufsicht auf einen Kontaktkörper des Zellverbinders aus den Fig. 1 bis 3.

Gleich oder funktional äquivalente Elemente sind in allen Figuren mit denselben Bezugszeichen bezeichnet.

Eine als Ganzes mit 100 bezeichnete elektrochemische Vorrichtung umfasst beispielsweise mehrere (nicht dargestellte) elektrochemische Module, von denen jedes mehrere, beispielsweise jeweils acht oder zwölf, elektrochemische Zellen 102 umfasst, welche jeweils in einer Aufnahme einer (nicht dargestellten) Aufnahmevorrichtung des Moduls aufgenommen sind.

Eine solche Aufnahmevorrichtung kann insbesondere als ein Kühlkörper ausgebildet sein, der mit den darin aufgenommenen elektrochemischen Zellen in wärmeleitendem Kontakt steht, und während des Betriebs der elektrochemischen Vorrichtung 100 Wärme von den elektrochemischen Zellen 102 abzuführen.

Die elektrochemischen Zellen102 sind in der sie umgebenden Aufnahmevorrichtung so angeordnet und ausgerichtet, dass Axialrichtungen 104 der elektrochemischen Zellen 102, welche parallel zu den mittigen Längsachsen 106 der elektrochemischen Zellen 102 verlaufen, im Wesentlichen parallel zueinander ausgerichtet sind.

Jede der elektrochemischen Zellen 102 erstreckt sich dabei von einem vorderen Zellterminal 108 in der jeweiligen Axialrichtung 104 bis zu einem (nicht dargestellten) hinteren Zellterminal, wobei jedes Zellterminal jeweils einen positiven Pol oder einen negativen Pol der elektrochemischen Zelle 102 bildet.

Die mittigen Längsachsen 106 der elektrochemischen Zellen 102 sind dabei zugleich mittige Längsachsen der Zellterminals 108 der jeweiligen elektrochemischen Zellen 102.

In einem Modul sind einander benachbarte elektrochemische Zellen 102 jeweils so ausgerichtet, dass die auf derselben Seite des Moduls angeordneten Zellterminals zweier benachbarter Zellen 102a, 102b einander entgegengesetzte Polarität aufweisen.

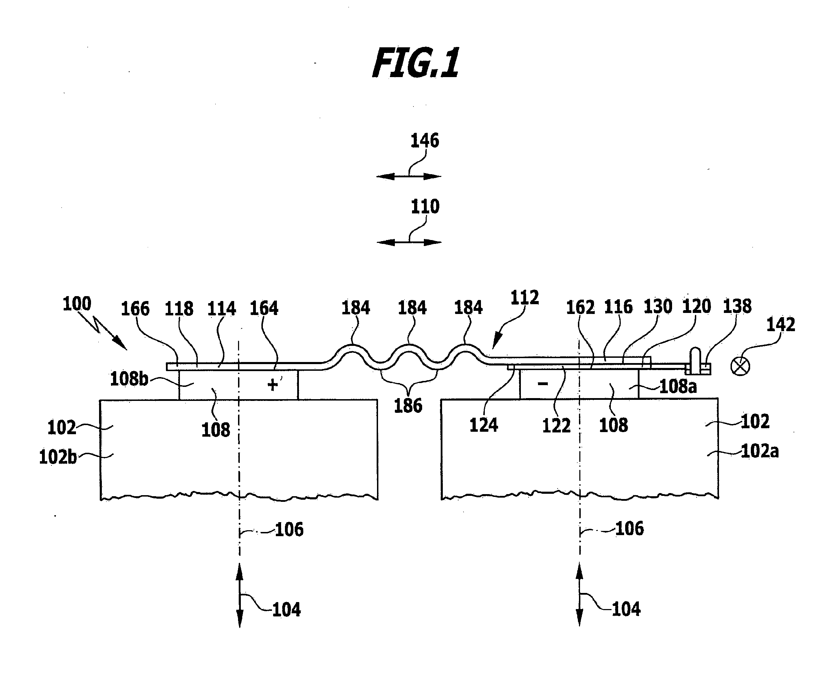

So bildet beispielsweise bei der in Fig. 1 dargestellten Zellanordnung das vordere Zellterminal 108a der elektrochemischen Zelle 102a einen negativen Pol der betreffenden elektrochemischen Zelle 102a, während das vordere Zellterminal 108b der in einer Verbindungsrichtung 110 der elektrochemischen Zelle 102a benachbarten elektrochemischen Zelle 102b einen positiven Pol der elektrochemischen Zelle 102b bildet.

Die elektrochemische Vorrichtung 100 kann insbesondere als ein Akkumulator, vorzugsweise als ein Lithium-Ionen-Akkumulator, beispielsweise des Typs LiFeP0₄, ausgebildet sein.

Die elektrochemischen Zellen 102 der elektrochemischen Module können entsprechend als Akkumulatorzellen, insbesondere als Lithium-Ionen-Akkumulatorzellen, beispielsweise vom Typ LiFePO₄, ausgebildet sein.

Jedes elektrochemische Modul umfasst ferner mehrere Zellverbinder 112, mittels welcher die Zellterminals 108 einander benachbarter elektrochemischer Zellen 102 mit unterschiedlicher Polarität elektrisch leitend miteinander verbunden sind, um auf diese Weise alle elektrochemischen Zellen 102 eines elektrochemischen Moduls elektrisch in Reihe zu schalten.

Dabei verbindet jeder Zellverbinder 112 ein erstes Zellterminal 108a negativer Polarität mit einem zweiten Zellterminal 108b positiver Polarität einer benachbarten elektrochemischen Zelle 102.

Um alle elektrochemischen Zellen 102 eines Moduls elektrisch in Reihe zu schalten, sind außer den vorderen Zellterminals 108 einander benachbarter elektrochemischer Zellen auch die hinteren Zellterminals einander benachbarter elektrochemischer Zellen eines Moduls durch (nicht dargestellte) Zellverbinder miteinander verbunden.

Jeder der Zellverbinder 112, welche jeweils ein erstes Zellterminal 108a und ein zweites Zellterminal 108b elektrisch leitend miteinander verbinden, umfasst einen Grundkörper 114 mit einem ersten Kontaktabschnitt 116, der im montierten Zustand des Zellverbinders 112 benachbart zu einem (beispielsweise negativen) ersten Zellterminal 108a einer elektrochemischen Zelle 102a angeordnet ist, und einem zweiten Kontaktabschnitt 118, der im montierten Zustand des Zellverbinders 112 mit einem (beispielsweise positiven) zweiten Zellterminal 108b einer anderen elektrochemischen Zelle 102b verbunden ist.

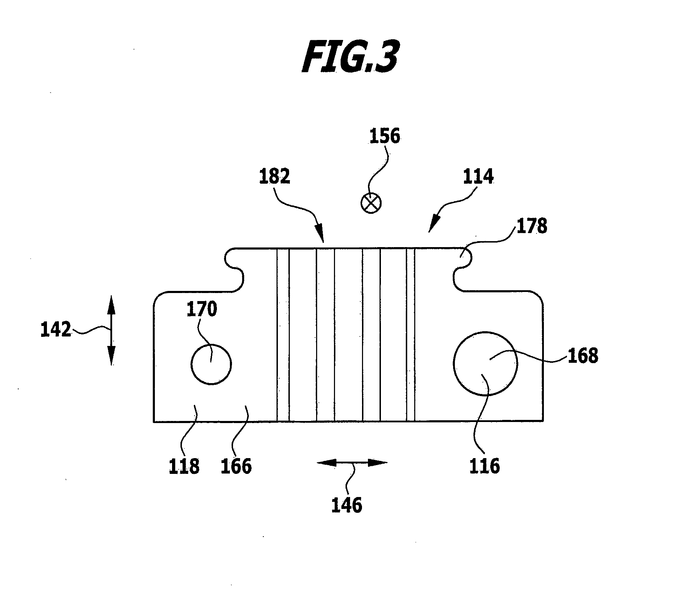

Der in Fig. 3 einzeln dargestellte Grundkörper 114 des Zellverbinders 112 ist vorzugsweise als ein Stanzbiegeteil hergestellt.

Der Grundkörper 114 des Zellverbinders 112 kann grundsätzlich aus jedem elektrisch leitfähigen Material, insbesondere aus einem metallischen Material, einem elektrisch leitfähigen Kunststoffmaterial und/oder einem leitfähigen Kohlenstoffmaterial, gebildet sein.

Insbesondere kann der Grundkörper 114 des Zellverbinders 112 aus Aluminium, Kupfer, Zinn, Zink, Eisen, Gold oder Silber oder aus einer Legierung eines oder mehrerer der vorstehend genannten Metalle gebildet sein.

Vorzugsweise ist der Grundkörper 114 des Zellverbinders 112 aus Aluminium oder einer Aluminiumlegierung oder aus Kupfer oder einer Kupferlegierung gebildet.

Der Grundkörper 114 kann einlagig oder mehrlagig ausgebildet sein.

Bei mehrlagiger Ausführung können mehrere Lagen des Grundkörpers 114 einstückig miteinander ausgebildet sein. Alternativ oder ergänzend hierzu kann auch vorgesehen sein, dass mehrere Lagen des Grundkörpers separat voneinander hergestellt und bei der Montage des Zellverbinders, insbesondere stoffschlüssig, miteinander verbunden werden.

Ferner umfasst der Zellverbinder 112 einen Kontaktkörper 120, der separat von dem Grundkörper 114 hergestellt und im Bereich des ersten Kontaktabschnitts 116, vorzugsweise stoffschlüssig, an der den Zellterminals 108 zugewandten Seite des Grundkörpers 114 festgelegt ist.

Der Kontaktkörper 120 kann insbesondere durch Verschweißung, beispielsweise Ultraschallschweißung, durch Verlötung und/oder durch Verklebung mit dem Grundkörper 114 des Zellverbinders 112 verbunden sein.

Auch der Kontaktkörper 120 ist vorzugsweise als ein Stanzbiegeteil hergestellt.

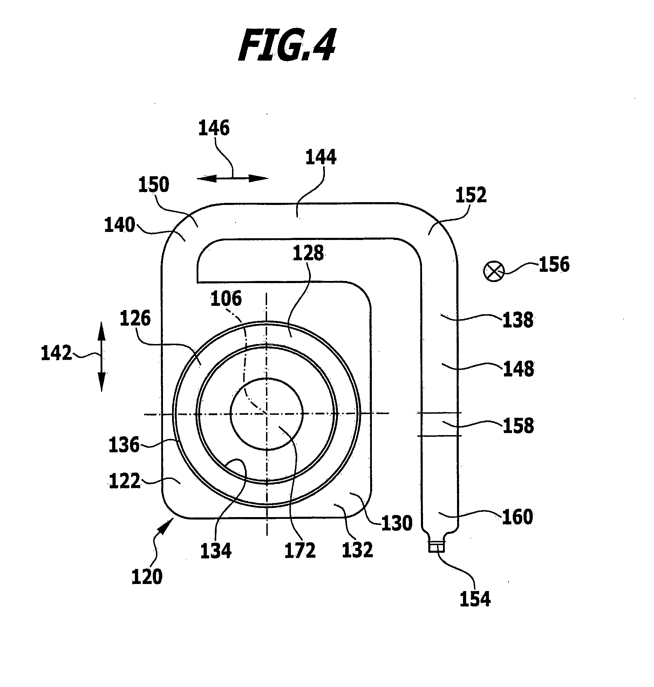

Der in Fig. 4 einzeln dargestellte Kontaktkörper 120 umfasst einen, beispielsweise im Wesentlichen rechteckigen, Kontaktbereich 122, der im montierten Zustand des Zellverbinders 112 mit einer dem Kontaktkörper 120 zugewandten Fügefläche 124 des Grundkörpers 114 verbunden ist und im montierten Zustand der elektrochemischen Vorrichtung 100 stoffschlüssig mit einem der Zellterminals 108, beispielsweise mit dem negativen ersten Zellterminal 108a, verbunden ist.

Insbesondere kann vorgesehen sein, dass der Kontaktbereich 122 des Kontaktkörpers 120 durch Verschweißung, insbesondere durch Laserschweißung, mit dem Zellterminal 108a, verbunden ist.

Um die Herstellung einer stoffschlüssigen Verbindung zwischen dem Kontaktbereich 122 des Kontaktkörpers 120 einerseits und dem ersten Kontaktabschnitt 116 des Grundkörpers 114 andererseits durch einen Ultraschallfügevorgang zu erleichtern, kann vorgesehen sein, dass der Kontaktbereich 122 mit einer zu dem Grundkörper 114 hin vorstehenden Erhebung 126 versehen ist, welche zu Beginn des Ultraschallfügevorgangs mit einer Kontaktfläche 128 an der Fügefläche 124 des Grundkörpers 114 anliegt, wobei die Kontaktfläche 128 kleiner ist als die gesamte, dem Grundkörper 114 zugewandte Fügefläche 130 des Kontaktbereichs 122 des Kontaktkörpers 120.

Während eines linearen oder torsionalen Ultraschallschweißvorgangs dringt die Erhebung 126 des Kontaktkörpers 120 in den Grundkörper 114 ein, bis die Erhebung 126 in das Material des Grundkörpers eingebettet ist und auch die außerhalb der Kontaktfläche 128 der Erhebung 126 liegende Restfläche 132 der Fügefläche 130 des Kontaktbereichs 122 an der Fügefläche 124 des Grundkörpers 114 anliegt.

Die Erhebung 126 kann beispielsweise ringförmig ausgebildet sein und kann beispielsweise als eine Doppel-Halbsicke ausgebildet sein, mit einer von einem inneren Rand der Kontaktfläche 128 zu der Restfläche 132 abfallenden inneren Flanke 134 und einer von einem äußeren Rand der Kontaktfläche 128 zur Restfläche 132 abfallenden äußeren Flanke 136.

Außer dem Kontaktbereich 122 umfasst der Kontaktkörper 120 einen, beispielsweise stegförmigen, Spannungsabgriff 138, welcher einstückig mit dem Kontaktbereich 122 des Kontaktkörpers 120 ausgebildet ist und sich von dem Kontaktbereich 122 weg erstreckt.

Insbesondere kann vorgesehen sein, dass der stegförmige Spannungsabgriff 138 einen mit dem Kontaktbereich 122 verbundenen Anfangsabschnitt 140 aufweist, welcher beispielsweise im Wesentlichen parallel zu einer Querrichtung 142 des Zellverbinders 112 verläuft, einen auf den Anfangsabschnitt 140 folgenden Mittelabschnitt 144 aufweist, welcher beispielsweise im Wesentlichen parallel zu einer Längsrichtung 146 des Zellverbinders 112 verläuft, und einen auf den Mittelabschnitt 144 folgenden Endabschnitt 148 aufweist, welcher beispielsweise im Wesentlichen parallel zur Querrichtung 142 des Zellverbinders 112 verläuft.

Die Querrichtung 142 und die Längsrichtung 146 des Zellverbinders 112 verlaufen senkrecht zueinander.

Dabei ist der Anfangsabschnitt 140 des Spannungsabgriffs 138 vorzugsweise über einen ersten gekrümmten Zwischenabschnitt mit dem Mittelabschnitt 144 des Spannungsabgriffs 138 verbunden, während der Mittelabschnitt 144 vorzugsweise über einen zweiten gekrümmten Zwischenabschnitt 152 mit dem Endabschnitt 148 verbunden ist.

Der Endabschnitt 148 des Spannungsabgriffs 138 ist an seinem freien Ende vorzugsweise mit einem Kontaktierungselement 154 zum Anschließen des Spannungsabgriffs 138 an eine (nicht dargestellte) Spannungsabgriffsleitung der elektrochemischen Vorrichtung 100 versehen.

Das Kontaktierungselement 154 kann beispielsweise als ein Lötpin ausgebildet sein, an welchem der Spannungsabgriff 138 mit einer Spannungsabgriffsleitung verlötbar ist.

Um die Höhenlage des Kontaktierungselements 154, das heißt dessen Positionierung in einer zu der Querrichtung 142 und zu der Längsrichtung 146 senkrechten Kontaktrichtung 156 des Zellverbinders 112, in gewünschter Weise gegenüber der Höhenlage des Kontaktbereichs 122 verändern zu können, kann der Spannungsabgriff 138, insbesondere in seinem Endabschnitt 148, mit einer Abkröpfung 158 versehen sein.

Die Abkröpfung 158 verläuft vorzugsweise im Wesentlichen quer, insbesondere im Wesentlichen senkrecht, zu einer Längsrichtung des Endabschnitts 148.

Der abgekröpfte Teil 160 des Spannungsabgriffs 138 kann im montierten Zustand der elektrochemischen Vorrichtung 100 grundsätzlich gegenüber dem Kontaktbereich 122 zu dem Zellterminal 108a hin oder von dem Zellterminal 108a weg versetzt sein.

Bei der in den Zeichnungen dargestellten Ausführungsform ist der abgekröpfte Teil 160 des Spannungsabgriffs 138 gegenüber dem Kontaktbereich 122 zu dem Zellterminal 108a hin versetzt.

Der Spannungsabgriff 138 weist vorzugsweise im Wesentlichen dieselbe mittlere Materialstärke auf wie der Kontaktbereich 122 des Kontaktkörpers 120.

Der einstückig ausgebildete Kontaktkörper 120 umfasst vorzugsweise ein von dem Material des Grundkörpers 114 verschiedenes Material und ist vorzugsweise im Wesentlichen vollständig aus einem von dem Material des Grundkörpers 114 verschiedenen Material gebildet.

Insbesondere kann vorgesehen sein, dass der Kontaktkörper 120 aus Nickel oder einer Nickellegierung gebildet ist.

Das stoffschlüssig mit dem Kontaktbereich 122 des Kontaktkörpers 120 verbundene Zellterminal 108a weist vorzugsweise eine Kontaktfläche 162 auf, welche denselben Hauptbestandteil enthält wie das Material des Kontaktkörpers 120.

Vorzugsweise ist die Kontaktfläche 162 des mit dem Kontaktbereich 122 des Kontaktkörpers 120 verbundenen Zellterminals 108a aus Nickel oder einer Nickellegierung gebildet.

Das mit dem ersten Zellterminal 108a über den Zellverbinder 112 elektrisch leitend verbundene zweite Zellterminal 108b weist hingegen vorzugsweise eine Kontaktfläche 164 auf, deren Hauptbestandteil mit dem Hauptbestandteil des Materials des Grundkörpers 114 übereinstimmt.

Wenn der Grundkörper 114 aus Aluminium oder einer Aluminiumlegierung gebildet ist, ist somit die Kontaktfläche 164 des zweiten Zellterminals 108b vorzugsweise ebenfalls aus Aluminium oder einer Aluminiumlegierung gebildet.

Der zweite Kontaktabschnitt 118 des Grundkörpers 114 ist unmittelbar, vorzugsweise stoffschlüssig, mit dem zweiten Zellterminal 108b verbunden.

Eine solche stoffschlüssige Verbindung kann insbesondere durch Verschwei-βung, insbesondere Laserverschweißung, oder durch Verlötung hergestellt werden.

Der zweite Kontaktabschnitt 118 des Grundkörpers 114 bildet somit einen zweiten Kontaktbereich 166 des Zellverbinders 112, der im montierten Zustand der elektrochemischen Vorrichtung 100 mit dem zweiten Zellterminal 108b verbunden ist, während der Kontaktbereich 122 des Kontaktkörpers 120 einen ersten Kontaktbereich des Zellverbinders 112 bildet, der im montierten Zustand der elektrochemischen Vorrichtung 100 mit dem ersten Zellterminal 108a verbunden ist.

Um auch nach dem stoffschlüssigen Verbinden des Zellverbinders 112 mit den Zellterminals 108a und 108b einen direkten Zugang, beispielsweise für Messzwecke, zu den Zellterminals 108a und 108b zu ermöglichen, können der erste Kontaktabschnitt 116 und der zweite Kontaktabschnitt 118 des Grundkörpers 114 sowie der Kontaktbereich 122 des Kontaktkörpers 120 jeweils mit einer, beispielsweise im Wesentlichen kreisförmigen, Durchtrittsöffnung 168, 170 bzw. 172 versehen sein (siehe die Fig. 3 und 4).

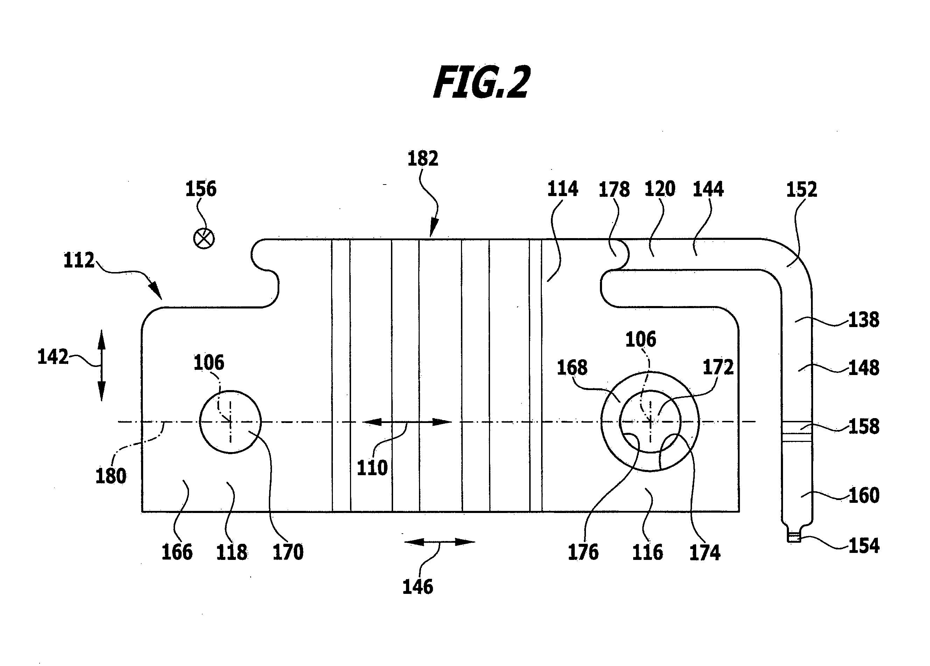

Dabei weist vorzugsweise die Durchtrittsöffnung 168 in dem ersten Kontaktabschnitt 116 des Grundkörpers 114 eine größere Durchtrittsfläche auf als die Durchtrittsöffnung 172 in dem Kontaktbereich 122 des Kontaktkörpers 120, so dass der Rand 174 der Durchtrittsöffnung 168 in dem ersten Kontaktabschnitt 116 den Rand 176 der Durchtrittsöffnung 172 in dem Kontaktbereich 122 des Kontaktkörpers 120, vorzugsweise im Wesentlichen konzentrisch, umgibt (siehe Fig. 2).

Wie ferner aus Fig. 2 zu ersehen ist, kann vorgesehen sein, dass der erste Kontaktabschnitt 116 des Grundkörpers 114 einen Vorsprung 178 aufweist, welcher mit dem Anfangsabschnitt 140 und dem ersten gekrümmten Zwischenabschnitt 150 des Spannungsabgriffs 138 des Kontaktkörpers 120 zumindest teilweise überlappt, so dass diese Abschnitte des Spannungsabgriffs 138 durch den Grundkörper 114 abgestützt sind.

Im Betrieb der elektrochemischen Vorrichtung 100 kann es aufgrund unterschiedlicher Temperaturen und/oder aufgrund unterschiedlicher thermischer Ausdehnungskoeffizienten der Zellverbinder 112 einerseits und der Aufnahmevorrichtung für die elektrochemischen Zellen 102 andererseits zu einer Differenz zwischen einer Längsdehnung der Zellverbinder 112 einerseits und einer Änderung des Abstands zwischen den Längsachsen 106 der durch die Zellverbinder 112 miteinander verbundenen Zellterminals 108a, 108b andererseits kommen. Durch eine Temperaturänderung werden die Relativpositionen der durch einen Zellverbinder 112 miteinander verbundenen Zellterminals 108a, 108b in der senkrecht zur Axialrichtung 104 der elektrochemischen Zellen 102 ausgerichteten Verbindungsrichtung 110 verändert.

Die Verbindungsrichtung 110 liegt in einer Ebene 180, welche die Längsachsen 106 der elektrochemischen Zellen 102a und 102b enthält (siehe Fig. 2). Ferner kann es aufgrund unterschiedlicher Längsdehnungen der miteinander durch einen Zellverbinder 112 verbundenen elektrochemischen Zellen 102a, 102b zu einer Veränderung der Relativpositionen zwischen den miteinander verbundenen Zellterminals 108a, 108b längs der Axialrichtung 104 der miteinander verbundenen elektrochemischen Zellen 102a, 102b kommen.

Um solche Differenzen zwischen einer Längsdehnung des Zellverbinders 112 einerseits und einer Änderung des Abstands zwischen den Längsachsen 106 der durch den Zellverbinder 112 miteinander verbundenen Zellterminals 108a, 108b andererseits und/oder solche Differenzen zwischen einer Längsdehnung einer ersten elektrochemischen Zelle 102a und einer zweiten elektrochemischen Zelle 102b, die durch den Zellverbinder 112 miteinander verbunden sind, kompensieren zu können, kann vorgesehen sein, dass der Zellverbinder 112 einen elastisch und/oder plastisch verformbaren Kompensationsbereich 182 umfasst, welcher zwischen dem ersten Kontaktbereich 122 und dem zweiten Kontaktbereich 166 des Zellverbinders 112 angeordnet ist und die beiden Kontaktbereiche 122 und 166 miteinander verbindet.

Vorzugsweise ist der Grundkörper 114 des Zellverbinders 112 mit einem solchen Kompensationsbereich 182 versehen.

Bei der in den Figuren dargestellten Ausführungsform eines Zellverbinders 112 weist der verformbare Kompensationsbereich 182 eine Wellenstruktur auf, wobei die Wellenstruktur eine oder mehrere, beispielsweise drei, Wellen mit einer parallel zur Axialrichtung 104 der durch den Zellverbinder 112 zu verbindenden Zellen 102a, 102b und im Wesentlichen senkrecht zu den Kontaktflächen, mit denen der Zellverbinder 112 im montierten Zustand am ersten Zellterminal 108a bzw. am zweiten Zellterminal 108b anliegt, gerichteten Amplitude umfasst. Diese Wellen weisen mehrere, beispielsweise drei, quer, vorzugsweise im Wesentlichen senkrecht, zur Axialrichtung 104 der elektrochemischen Zellen 102 und quer, vorzugsweise im Wesentlichen senkrecht, zu der Längsrichtung 146 des Zellverbinders 112 und im Wesentlichen parallel zu der Querrichtung 142 des Zellverbinders 112 verlaufende Wellenberge 184 und mehrere, zwischen den Wellenbergen 184 angeordnete und quer, vorzugsweise im Wesentlichen senkrecht, zur Axialrichtung 104 der elektrochemischen Zellen 102 und quer, vorzugsweise im Wesentlichen senkrecht, zur Längsrichtung 146 des Zellverbinders 112 und im Wesentlichen parallel zur Querrichtung 142 des Zellverbinders 112 verlaufende Wellentäler 186 auf.

Im montierten Zustand der elektrochemischen Vorrichtung 100 verläuft die Längsrichtung 146 des Zellverbinders 112 im Wesentlichen parallel zur Verbindungsrichtung 110, und die Querrichtung 142 des Zellverbinders 112 verläuft im Wesentlichen senkrecht zur Verbindungsrichtung 110.

Die Wellenberge 184 stehen in der zu den Kontaktflächen des Zellverbinders 112 senkrechten Kontaktrichtung 156 des Zellverbinders 112, die im montierten Zustand der elektrochemischen Vorrichtung 100 mit der Axialrichtung 104 der elektrochemischen Zellen 102 übereinstimmt, nach oben vor, während die Wellentäler 186 in der Kontaktrichtung 156 nach unten (das heißt zu den miteinander zu verbindenden Zellen 102 hin) vorstehen.

Durch die gewellte Struktur des verformbaren Kompensationsbereichs 124 des Zellverbinders 112 wird erreicht, dass der Kompensationsbereich 124 in einfacher Weise derart elastisch und/oder plastisch verformbar ist, dass der zweite Kontaktbereich 166 relativ zu dem ersten Kontaktbereich 122 sowohl in der Axialrichtung 104 der elektrochemischen Zellen 102 als auch in der Längsrichtung 146 des Zellverbinders 112 verschoben werden kann, um die vorstehend beschriebenen Differenzen in den Relativpositionen der durch den Zellverbinder 112 miteinander zu verbindenden Zellterminals 108a und 108b auszugleichen. Hierdurch kann das Auftreten übermäßiger mechanischer Spannungen an den Verbindungsstellen zwischen dem Zellverbinder 112 einerseits und dem ersten Zellterminal 108 sowie dem zweiten Zellterminal 108b andererseits vermieden werden.

Zur Herstellung des Zellverbinders 112, wie er in den Fig. 1 und 2 dargestellt ist, wird wie folgt vorgegangen:

Zunächst wird eine Grundkörper-Vorform aus einem Ausgangsmaterial, beispielsweise aus einem blechförmigen Ausgangsmaterial, herausgetrennt, beispielsweise ausgestanzt oder (zum Beispiel mittels eines Lasers) herausgeschnitten.

In die Grundkörper-Vorform werden durch geeignete Umformvorgänge, insbesondere Präge- oder Tiefziehvorgänge, die Wellenberge 184 und Wellentäler 186 des Kompensationsbereichs 182 eingebracht.

Die Durchtrittsöffnung 168 des ersten Kontaktabschnitts 116 und die Durchtrittsöffnung 170 des zweiten Kontaktabschnitts 118 können bereits vor diesen Umformvorgängen, beispielsweise zusammen mit dem Heraustrennen der Außenkontur der Grundkörper-Vorform aus dem Ausgangsmaterial, oder nach den Umformvorgängen aus der Grundkörper-Vorform herausgetrennt werden.

Damit ist die Herstellung des Grundkörpers 114 des Zellverbinders 112 abgeschlossen.

Der Kontaktkörper 120 wird ebenfalls, separat von dem Grundkörper 114, aus einem Ausgangsmaterial, beispielsweise aus einem blechförmigen Ausgangsmaterial, herausgetrennt, beispielsweise ausgestanzt oder (zum Beispiel mittels eines Lasers) herausgeschnitten.

Ferner werden durch geeignete Umformvorgänge, insbesondere Präge- oder Tiefziehvorgänge, die Erhebung 126 im Kontaktbereich 122 des Kontaktkörpers 120 und die Abkröpfung 158 am Spannungsabgriff 138 des Kontaktkörpers 120 erzeugt.

Die Durchtrittsöffnung 172 in dem Kontaktbereich 122 des Kontaktkörpers 120 kann bereits vor diesen Umformvorgängen, beispielsweise zusammen mit dem Heraustrennen der Außenkontur des Kontaktkörpers 120 aus dem Ausgangsmaterial, oder nach den Umformvorgängen aus dem Kontaktkörper 120 herausgetrennt werden.

Der Kontaktkörper 120 wird, vorzugsweise stoffschlüssig, mit dem Grundkörper 114 verbunden.

Diese Verbindung erfolgt vorzugsweise durch einen Ultraschallschweißvorgang.

Der so aus dem Grundkörper 114 und dem Kontaktkörper 120 hergestellte Zellverbinder 112 wird in den Kontaktbereichen 122 und 166, vorzugsweise stoffschlüssig, mit jeweils einem Zellterminal 108 einer elektrochemischen Zelle 102 verbunden.

Das Kontaktierungselement 154 des Spannungsabgriffs 138 des Kontaktkörpers 120 wird, beispielsweise durch Verlötung, an eine (nicht dargestellte) Spannungsabgriffsleitung angeschlossen, welche zu einer (ebenfalls nicht dargestellten) Auswertungseinheit der elektrochemischen Vorrichtung 100 führt.

## Patentansprüche

1. Elektrochemische Vorrichtung, umfassend
mindestens eine erste elektrochemische Zelle (102a) mit einem ersten Zellterminal (108a) und eine zweite elektrochemische Zelle (102b) mit einem zweiten Zellterminal (108b) und
mindestens einen Zellverbinder zum elektrisch leitenden Verbinden des ersten Zellterminals (108a) und des zweiten Zellterminals (108b),
wobei der Zellverbinder (112)
einen Grundkörper (114) und
einen Kontaktkörper (120), der mit dem Grundkörper (114) verbunden ist und im montierten Zustand des Zellverbinders (112) mit einem der Zellterminals (108a, 108b) verbunden ist,
umfasst und der Kontaktkörper (120) an einer im montierten Zustand des Zellverbinders (112) den Zellterminals (108a, 108b) zugewandten Seite des Grundkörpers (114) festgelegt ist,
**dadurch gekennzeichnet,**
**dass** der Kontaktkörper (120) einen Spannungsabgriff (138) umfasst.

2. Elektrochemische Vorrichtung nach Anspruch 1, **dadurch gekennzeichnet, dass** der Spannungsabgriff (138) stegförmig ausgebildet ist.

3. Elektrochemische Vorrichtung nach einem der Ansprüche 1 oder 2,
**dadurch gekennzeichnet, dass** der Kontaktkörper (120) einen Kontaktbereich (122) umfasst, der im montierten Zustand des Zellverbinders (112) mit einer Fügefläche (124) des Grundkörpers (114) verbunden ist und einstückig mit dem Spannungsabgriff (138) ausgebildet ist.

4. Elektrochemische Vorrichtung nach einem der Ansprüche 1 bis 3,
**dadurch gekennzeichnet, dass** der Grundkörper (114) ein erstes Material und der Kontaktkörper (120) ein zweites Material, das von dem ersten Material verschieden ist, umfasst.

5. Elektrochemische Vorrichtung nach einem der Ansprüche 1 bis 4,
**dadurch gekennzeichnet, dass** der Grundkörper (114) Aluminium und/oder Kupfer umfasst.

6. Elektrochemische Vorrichtung nach einem der Ansprüche 1 bis 5,
**dadurch gekennzeichnet, dass** der Kontaktkörper (120) Nickel umfasst.

7. Elektrochemische Vorrichtung nach einem der Ansprüche 1 bis 6,
**dadurch gekennzeichnet, dass** der Kontaktkörper (120) stoffschlüssig mit dem Grundkörper (114) verbunden ist.

8. Elektrochemische Vorrichtung nach Anspruch 7, **dadurch gekennzeichnet, dass** der Kontaktkörper (120) durch Verschweißung mit dem Grundkörper (114) verbunden ist.

9. Elektrochemische Vorrichtung nach einem der Ansprüche 1 bis 8,
**dadurch gekennzeichnet, dass** der Spannungsabgriff (138) ein Kontaktierungselement (154) zum Anschließen an eine Spannungsabgriffsleitung der elektrochemischen Vorrichtung (100) aufweist.

10. Elektrochemische Vorrichtung nach einem der Ansprüche 1 bis 9,
**dadurch gekennzeichnet, dass** der Kontaktkörper (120) stoffschlüssig mit einem der Zellterminals (108a, 108b) verbunden ist.

11. Elektrochemische Vorrichtung nach Anspruch 10, **dadurch gekennzeichnet, dass** der Kontaktkörper (120) durch Verschweißung mit einem der Zellterminals (108a, 108b) verbunden ist.

12. Elektrochemische Vorrichtung nach einem der Ansprüche 1 bis 11, **dadurch gekennzeichnet, dass** das mit dem Kontaktkörper (120) verbundene Zellterminal (108a) eine Kontaktfläche (162) aufweist, deren Material denselben Hauptbestandteil aufweist wie das Material des Kontaktbereichs (120).

13. Elektrochemische Vorrichtung nach einem der Ansprüche 1 bis 12, **dadurch gekennzeichnet, dass** das mit dem Kontaktkörper (120) verbundene Zellterminal (108a) eine Kontaktfläche (162) aufweist, deren Material Nickel enthält.

14. Verfahren zum Herstellen einer elektrisch leitenden Verbindung zwischen einem ersten Zellterminal (108a) einer ersten elektrochemischen Zelle (102a) und einem zweiten Zellterminal (108b) einer zweiten elektrochemischen Zelle (102b) einer elektrochemischen Vorrichtung (100), umfassend folgende Verfahrensschritte:
- Herstellen eines Grundkörpers (114) eines Zellverbinders (112);
- Herstellen eines Kontaktkörpers (120) eines Zellverbinders (112) separat von dem Grundkörper (114), wobei der Kontaktkörper (120) einen Spannungsabgriff (138) umfasst;
- Verbinden des Kontaktkörpers (120) mit dem Grundkörper (114) wobei der Kontaktkörper (120) an einer im montierten Zustand des Zellverbinders (112) den Zellterminals (108a, 108b) zugewandten Seite des Grundkörpers (114) festgelegt wird;
- Verbinden eines der Zellterminals (108a) mit dem Kontaktkörper (120);
- Verbinden des Zellverbinders (112) mit dem anderen Zellterminal (108b);
- Verbinden des Spannungsabgriffs (138) mit einer Spannungsabgriffsleitung der elektrochemischen Vorrichtung (100).

## Claims

1. Electrochemical device, comprising at least one first electrochemical cell (102a) with a first cell terminal (108a) and a second electrochemical cell (102b) with a second cell terminal (108b) and at least one cell connector for the electrically conductive connection of the first cell terminal (108a) and the second cell terminal (108b), wherein the cell connector (112) comprises a base body (114) and a contact body (120), which is connected to the base body (114) and, in the assembled state of the cell connector (112), is connected to one of the cell terminals (108a, 108b), and the contact body (120) is fixed on a side of the base body (114) facing the cell terminals (108a, 108b) in the assembled state of the cell connector (112), **characterised in that** the contact body (120) comprises a voltage tap (138).

2. Electrochemical device according to claim 1, **characterised in that** the voltage tap (138) is strip-like.

3. Electrochemical device according to either of claims 1 or 2, **characterised in that** the contact body (120) comprises a contact region (122), which, in the assembled state of the cell connector (112), is connected to a joining face (124) of the base body (114) and is formed in one piece with the voltage tap (138).

4. Electrochemical device according to any one of claims 1 to 3, **characterised in that** the base body (114) comprises a first material and the contact body (120) comprises a second material, which is different from the first material.

5. Electrochemical device according to any one of claims 1 to 4, **characterised in that** the base body (114) comprises aluminium and/or copper.

6. Electrochemical device according to only one of claims 1 to 5, **characterised in that** the contact body (120) comprises nickel.

7. Electrochemical device according to any one of claims 1 to 6, **characterised in that** the contact body (120) is connected by a substance-to-substance bond to the base body (114).

8. Electrochemical device according to claim 7, **characterised in that** the contact body (120) is connected to the base body (114) by welding.

9. Electrochemical device according to any one of claims 1 to 8, **characterised in that** the voltage tap (138) has a contacting element (154) for connection to a voltage tap line of the electrochemical device (100).

10. Electrochemical device according to any one of claims 1 to 9, **characterised in that** the contact body (120) is connected by a substance-to-substance bond to one of the cell terminals (108a, 108b).

11. Electrochemical device according to claim 10, **characterised in that** the contact body (120) is connected to one of the cell terminals (108a, 108b) by welding.

12. Electrochemical device according to any one of claims 1 to 11, **characterised in that** the cell terminal (108a) connected to the contact body (120) has a contact face (162), the material of which has the same main constituent as the material of the contact region (120).

13. Electrochemical device according to any one of claims 1 to 12, **characterised in that** the cell terminal (108a) connected to the contact body (120) has a contact face (162), the material of which contains nickel.

14. Method for producing an electrically conductive connection between a first cell terminal (108a) of a first electrochemical cell (102a) and a second cell terminal (108b) of a second electrochemical cell (102b) of an electrochemical device (100), comprising the following method steps:
- producing a base body (114) of a cell connector (112);
- producing a contact body (120) of a cell connector (112) separately from the base body (114), the contact body (120) comprising a voltage tap (138);
- connecting the contact body (120) to the base body (114), the contact body (120) being fixed on a side of the base body (114) facing the cell terminals (108a, 108b) in the assembled state of the cell connector (112);
- connecting one of the cell terminals (108a) to the contact body (120);
- connecting the cell connector (112) to the other cell terminal (108b);
- connecting the voltage tap (138) to a voltage tap line of the electrochemical device (100).

## Revendications

1. Dispositif électrochimique, comprenant
au moins une première cellule électrochimique (102a) avec une première borne de cellule (108a) et une deuxième cellule électrochimique (102b) avec une deuxième borne de cellule (108b) ; et
au moins un raccord de cellules pour la liaison électriquement conductrice de la première borne de cellule (108a) et de la deuxième borne de cellule (108b),
dans lequel le raccord de cellules (112) comprend
un corps de base (114) et
un corps de contact (120), qui est relié au corps de base (114) et qui, dans l'état monté du raccord de cellules (112), est relié à une des bornes de cellule (108a, 108b),
et le corps de contact (120) est fixé sur un côté du corps de base (114) tourné vers les bornes de cellule (108a, 108b) dans l'état monté du raccord de cellules (112), est
**caractérisé en ce que** le corps de contact (120) présente une prise de tension (138).

2. Dispositif électrochimique selon la revendication 1, **caractérisé en ce que** la prise de tension (138) est réalisée en forme d'ailette.

3. Dispositif électrochimique selon l'une des revendications 1 ou 2, **caractérisé en ce que** le corps de contact (120) comprend une zone de contact (122) qui, dans l'état monté du raccord de cellule (112), est reliée à une face de jonction (124) du corps de base (114) et qui est réalisée d'une seule pièce avec la prise de tension (138).

4. Dispositif électrochimique selon l'une quelconque des revendications 1 à 3, **caractérisé en ce que** le corps de base (114) comprend un premier matériau et le corps de contact (120) comprend un deuxième matériau, qui est différent du premier matériau.

5. Dispositif électrochimique selon l'une quelconque des revendications 1 à 4, **caractérisé en ce que** le corps de base (114) comprend de l'aluminium et/ou du cuivre.

6. Dispositif électrochimique selon l'une quelconque des revendications 1 à 5, **caractérisé en ce que** le corps de contact (120) comprend du nickel.

7. Dispositif électrochimique selon l'une quelconque des revendications 1 à 6, **caractérisé en ce que** le corps de contact (120) est relié par complémentarité de matière au corps de base (114).

8. Dispositif électrochimique selon la revendication 7, **caractérisé en ce que** le corps de contact (120) est assemblé au corps de base (114) par soudage.

9. Dispositif électrochimique selon l'une quelconque des revendications 1 à 8, **caractérisé en ce que** la prise de tension (138) présente un élément de contact (154) pour le raccordement à un conducteur de prise de tension du dispositif électrochimique (100).

10. Dispositif électrochimique selon l'une quelconque des revendications 1 à 9, **caractérisé en ce que** le corps de contact (120) est relié par complémentarité de matière à une des bornes de cellule (108a, 108b).

11. Dispositif électrochimique selon la revendication 10, **caractérisé en ce que** le corps de contact (120) est assemblé à une des bornes de cellule (108a, 108b) par soudage.

12. Dispositif électrochimique selon l'une quelconque des revendications 1 à 11, **caractérisé en ce que** la borne de cellule (108a) assemblée au corps de contact (120) présente une face de contact (162), dont le matériau présente le même composant principal que le matériau de la zone de contact (122).

13. Dispositif électrochimique selon l'une quelconque des revendications 1 à 12, **caractérisé en ce que** la borne de cellule (108a) assemblée au corps de contact (120) présente une face de contact (162), dont le matériau contient du nickel.

14. Procédé de fabrication d'une liaison électriquement conductrice entre une première borne de cellule (108a) d'une première cellule électrochimique (102a) et une deuxième borne de cellule (108b) d'une deuxième cellule électrochimique (102b) d'un dispositif électrochimique (100), comprenant les étapes suivantes :
- fabrication d'un corps de base (114) d'un raccord de cellules (112) ;
- fabrication d'un corps de contact (120) d'un raccord de cellules (112) séparément du corps de base (114), dans lequel le corps de contact (120) présente une prise de tension (138) ;
- liaison du corps de contact (120) avec le corps de base (114), dans lequel le corps de contact (120) est fixé sur un côté du corps de base (114) tourné vers les bornes de cellule (108a, 108b), dans l'état monté du raccord de cellules (112) ;
- assemblage d'une des bornes de cellule (108a) avec le corps de contact (120) ;
- assemblage du raccord de cellules (112) avec l'autre borne de cellule (108b) ;
- liaison de la prise de tension (138) avec un conducteur de prise de tension du dispositif électrochimique (100).
